Europäisches Patentamt

European Patent Office

Office européen des brevets

(11) Publication number: **0 290 497 B1**

# EUROPEAN PATENT SPECIFICATION

(45) Date of publication of patent specification: **17.03.93**   (51) Int. Cl.5: **H05K 7/20, H01L 23/46**

(21) Application number: **87906905.2**

(22) Date of filing: **08.10.87**

(86) International application number:
**PCT/US87/02583**

(87) International publication number:
**WO 88/02979 (21.04.88 88/09)**

(54) **LIOUID COOLING SYSTEM FOR INTEGRATED CIRCUITS.**

(30) Priority: **14.10.86 US 918054**
        **14.10.86 US 918057**

(43) Date of publication of application:
        **17.11.88 Bulletin 88/46**

(45) Publication of the grant of the patent:
        **17.03.93 Bulletin 93/11**

(84) Designated Contracting States:
        **BE DE FR GB IT NL SE**

(56) References cited:
        **DE-A- 1 035 918**
        **DE-A- 2 548 655**
        **US-A- 3 774 677**
        **US-A- 4 341 432**
        **US-A- 4 558 395**

        **IBM TECHNICAL DISCLOSURE BULLETIN, vol. 18, no. 2, July 1985, (New York, US), K.C. Joski: "Water packaging with an interposer", page 352**

        **IBM TECHNICAL DISCLOSURE BULLETIN, vol.**

**12, no. 11, April 1970, (US)O.R. Gupta et al.: "Cascaded gravity feed manifold", pages 1845-1946**

(73) Proprietor: **Unisys Corporation**
        **P.O. Box 500**
        **Blue Bell Pennsylvania 19424(US)**

(72) Inventor: **TUSTANIWSKYJ, Jerry, Ihor**
        **26822 Ave. Domingo**
        **Mission Viejo, CA 92691(US)**
        Inventor: **HALKOLA, Kyle, George**
        **5723 Cole Street**
        **US - San Diegeo, CA 92117(US)**

(74) Representative: **Eisenführ, Speiser & Partner**
        **Martinistrasse 24**
        **W-2800 Bremen 1 (DE)**

**Description**

BACKGROUND OF THE INVENTION

This invention relates to systems for cooling electrical components; and more particularly, it relates to systems for cooling integrated circuit packages with a liquid in a digital computer.

Initially in the prior art, integrated circuits in digital computers were cooled by convection with air. Typically, the integrated circuits of the computer were mounted on several printed circuit boards which in turn were mounted in a frame. Then one or more fans were provided within the frame to simply blow air across the integrated circuits. Such a cooling system is relatively inexpensive; however, it also has several major limitations.

For example, as the amount of circuitry on an integrated circuit chip increases, the amount of power and the amount of heat which that chip dissipates also increases. Thus a point is eventually reached with very large scale integrated circuits or with multichip integrated circuit packages at which the power dissipation is simply too high to allow cooling by air convection. Also, the logic gates in integrated circuit packages operate at slower speeds as their operating temperature is raised. Further, integrated circuits are more prone to failure when they are operated at higher temperature.

Accordingly, in the prior art, systems for cooling integrated circuits by conduction with a liquid have been developed. One such system which IBM uses for example in their 3081 computers, consists essentially of a plurality of 3081 multichip cooling modules. Each module includes a base plate, a substrate with several integrated circuit chips, a piston holding plate, and a cold plate with water channels. These items are bolted together one on top of the other in the above recited order.

Formed in the piston holding plate are several cylinders, each of which contains a helical spring and a piston. In operation, each spring pushes a piston against a respective integrated circuit chip on the substrate; and heat from each chip then travels in a serial fashion through the piston, through the cylinder sidewalls, and into the cold plate to the water.

However, cooling in this IBM module is still substantially limited because the water does not flow directly over the surface of the integrated circuit chips, and because thermal conduction between a piston and a cylinder sidewall is poor. In addition, liquid can leak from the cold plate at its input port or its output port when a defective connection is there made since the liquid passes through the cold plate under high pressure.

In another liquid cooling system, which is used in Cray-2 supercomputers, multichip circuit modules are completely immersed in a liquid bath. But this makes it cumbersome to remove a module for repair. Also, only inert liquids can be used; otherwise conductive traces which interconnect the circuit chips will corrode. Further, the liquid must have a very low dielectric constant so that electrical signals on the conductive traces do not propagate slowly. To meet these requirements, Cray-2 uses a special liquid called FC-77. But its surface tension is four times smaller than the surface tension of water; and this places considerable demands on the seals and gaskets in the cooling system - otherwise they will leak.

BRIEF SUMMARY OF THE INVENTION

In accordance of the invention, a leak tolerant cooling system, which cools electrical components with a liquid, comprises:

a frame holding a plurality of said electrical components;

a top reservoir, mounted on said frame above said components, holding said liquid;

a conduit means, coupled to said top reservoir and said components, conveying said liquid in a downward direction from said top reservoir over said components;

a bottom reservoir, coupled to said conduit means below said components, receiving said liquid from said conduit means as well as any air which happens to leak into said conduit means; and

a control means, coupled to said bottom reservoir;

said control means including: (a) a pump which sucks said liquid and said air through said conduit means at subatmospheric pressures and into said bottom reservoir in response to a control signal;

(b) a means for generating said control signal beginning when said liquid in said bottom reservoir is at a predetermined high level and continuing until a certain amount of said liquid in said bottom reservoir is displaced with said air and reaches a predetermined low level; and (c) a valve positioned on said bottom reservoir above the liquid therein which opens when said pump is stopped and allows said air to be pushed out of said bottom reservoir through said conduit means and into said bottom reservoir due to gravity.

Further advantageous embodiments are defined in claims 2 to 8.

BRIEF DESCRIPTION OF THE DRAWINGS

Various features and advantages of the invention are described in detail in the Detailed Description in conjunction with the following drawings wherein:

FIG. 1 illustrates a leak tolerant liquid cooling system for electrical components which is constructed in accordance with the invention;

FIGs. 2A-2D illustrate the operation of the FIG. 1 system under the condition where an air leak develops in a conduit within the system;

FIGs. 3A-3D illustrate the operation of the FIG. 1 system while a printed circuit board is removed from the system;

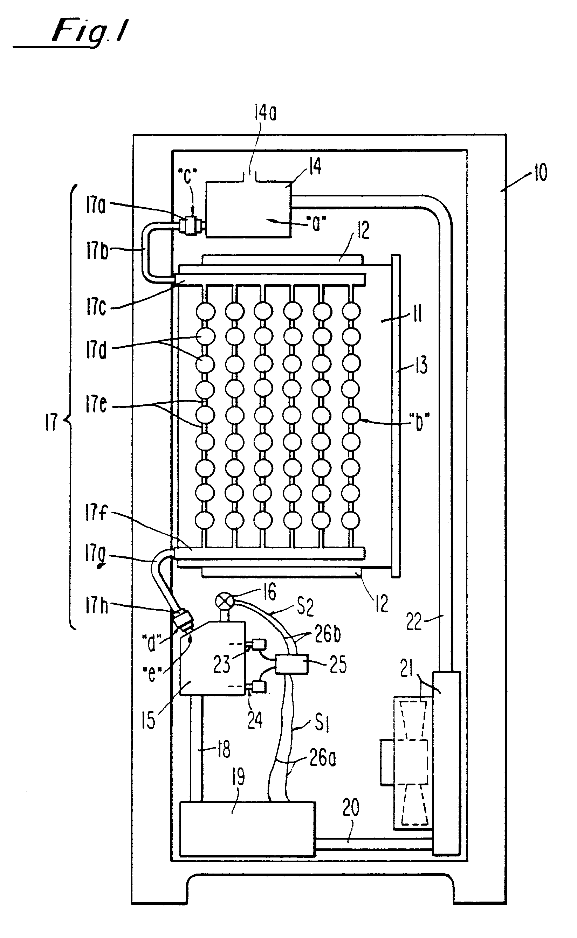

Page 15 gives a set of equations which show how the FIG. 1 system operates at subatmospheric pressures when a pump in the system is running; and

Page 16 gives a set of equations which show how the FIG. 1 system operates at subatmospheric pressures when a pump in the system is off.

DETAILED DESCRIPTION OF THE INVENTION

A preferred embodiment of the invention will now be described in conjunction with FIG. 1. That embodiment includes a frame 10 in which a plurality of printed circuit boards 11 are mounted. Only one of the boards 11 is shown in FIG. 1, but the remaining boards are disposed in a parallel fashion behind the illustrated board. These boards are held in place by card guides 12 and they plug into a backplane 13.

Also included in the FIG. 1 embodiment is a top reservoir 14 which is attached to frame 10 above the printed circuit boards. This reservoir 14 has an opening 14a which causes any liquid in the reservoir to be at atmospheric pressure. Lying below the printed circuit boards 11 is a bottom reservoir 15. This reservoir 15 is airtight except that it includes a valve 16 which can be opened to place the bottom reservoir at atmospheric pressure.

A conduit 17 is also included in the FIG. 1 embodiment. It runs from the top reservoir 14, over the printed circuit boards 11, to the bottom reservoir 15. In operation, liquid from the top reservoir 14 passes through the conduit to the bottom reservoir; and in so passing the liquid cools the electrical components on the printed circuit boards.

Several parts 17a thru 17h make up the conduit 17 as indicated in FIG. 1. Items 17a and 17h are valved couplers; items 17b and 17g are flexible tubes; items 17c and 17f are metal or plastic manifolds; items 17d are cooling modules for the electrical components; and items 17e are tubes for interconnecting the cooling modules. A separate conduit 17 is provided for each of the printed circuit boards.

Liquid in the bottom reservoir 15 passes through a pipe 18 to a pump 19. This pump sucks the liquid from the top reservoir through the conduit 17 to the bottom reservoir. Then the pump 19 returns the liquid back to the top reservoir 14 through a pipe 20, a heat exchanger 21, and another pipe 22.

Two level sensors 23 and 24, along with a relay circuit 25, are also included in the FIG. 1 system as shown. They control the operation of the pump 19 as well as the valve 16. Sensor 23 detects when the level of the liquid in the bottom reservoir 15 is at a predetermined high level, whereas sensor 24 detects when that liquid is at a predetermined low level.

Circuit 25 responds to the level sensors 23 and 24 by generating a control signal $S_1$ on conductors 26a which turn the pump 19 on, beginning when the liquid in the bottom reservoir 15 is at the high level, and continuing until the liquid in the bottom reservoir is at the low level. During this time, valve 16 is closed.

Conversely, circuit 25 generates a control signal $S_2$ on conductors 26b which open valve 16 beginning when the liquid in the bottom reservoir 15 is at the low level, and continuing until the liquid in the bottom reservoir reaches the high level. During this time, pump 19 is off.

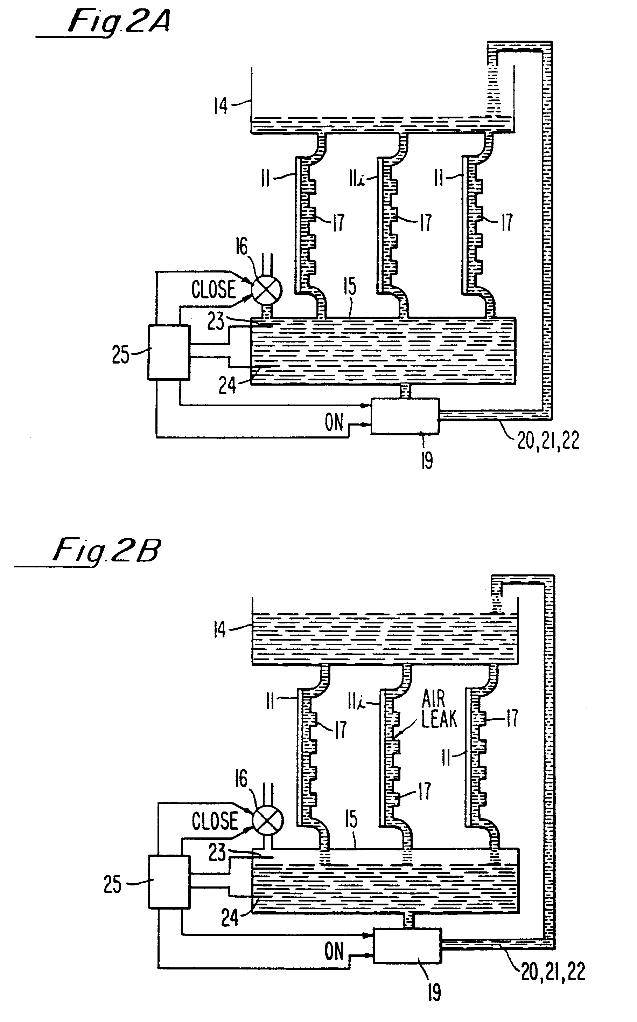

Reference should now be made to FIGs. 2A-2D which illustrate the operation of the FIG. 1 cooling system under the conditions where a small leak develops in the conduit 17 on one of the boards 11. Initially, as shown in FIG. 2A, there are no leaks, and liquid circulates through the system in a normal fashion. In this state, the liquid is sucked by the pump 19 from the top reservoir 14 through the respective conduits 17 on the printed circuit boards 11 to the bottom reservoir 15; and simultaneously, the liquid is pumped back to the top reservoir.

Subsequently, as shown in FIG. 2B, a small leak develops in the conduit on one of the printed circuit boards 11i. This leak may be caused, for example, by a faulty seal in a liquid cooling module 17d; or it could be caused by a faulty connection between a tube 17e and a cooling module.

When such a leak occurs, fluid does not squirt out of the conduit. Instead, air is sucked into the conduit 17 because, as will be explained in conjunction with FIG. 4, the liquid flows through the conduit 17 at

3

subatmospheric pressures. Air which is sucked into conduit 17 passes to the bottom reservoir 15 where it accumulates. Thus, as shown in FIG. 2B, the liquid level in the bottom reservoir 15 drops at a rate which is proportional to the rate at which air is leaked into the conduit.

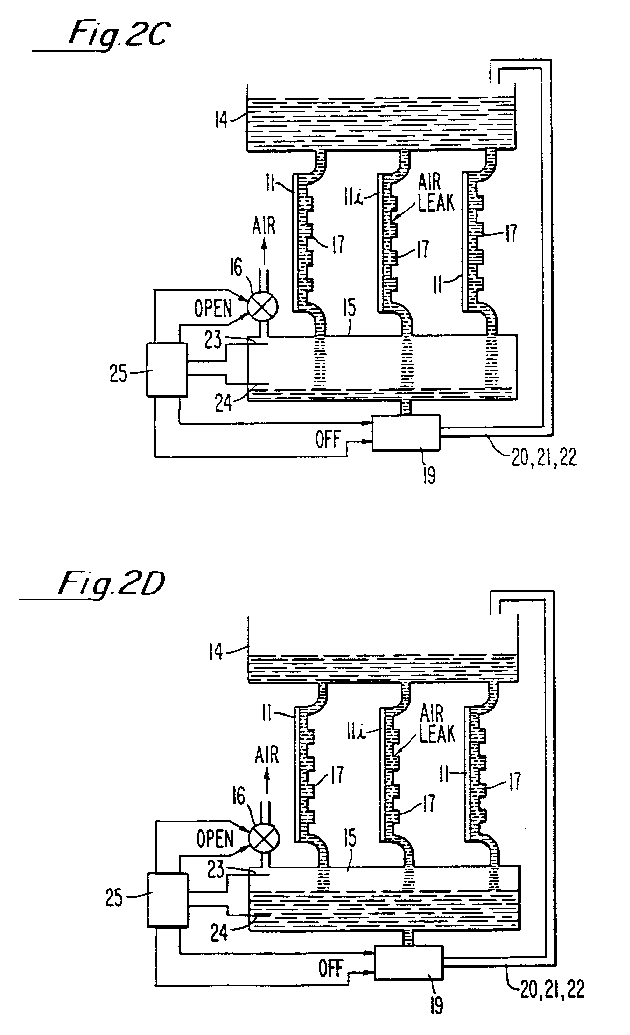

If the leak is small in comparison to the size of the bottom reservoir 15, several hours may pass before the liquid in the bottom reservoir gets to the predetermined low level. During this time, the liquid continues to flow through the conduit 17 and cool the electrical components on the printed circuit boards. Eventually, however, the state of FIG. 2C is reached in which sensor 24 detects that the liquid level in the bottom reservoir 15 is too low.

In response, pump 19 is turned off and valve 16 is opened. Consequently, liquid is no longer pumped from the bottom reservoir 15. But liquid does continue to flow from the top reservoir, due to gravity, through the conduit 17 and into the bottom reservoir 15. Thus, as shown in FIG. 2D, the bottom reservoir 15 begins to fill up, and this purges the air from the bottom reservoir through valve 16.

When the liquid in the bottom reservoir 15 reaches the predetermined high level, it is detected by sensor 23. In response, pump 19 turns on and valve 16 closes. This returns the operation of the system back to that which is shown in FIG. 2A. Thus the system will continue to cycle through the operating modes of FIGs. 2A-2D until the air leak in conduit 17 is fixed.

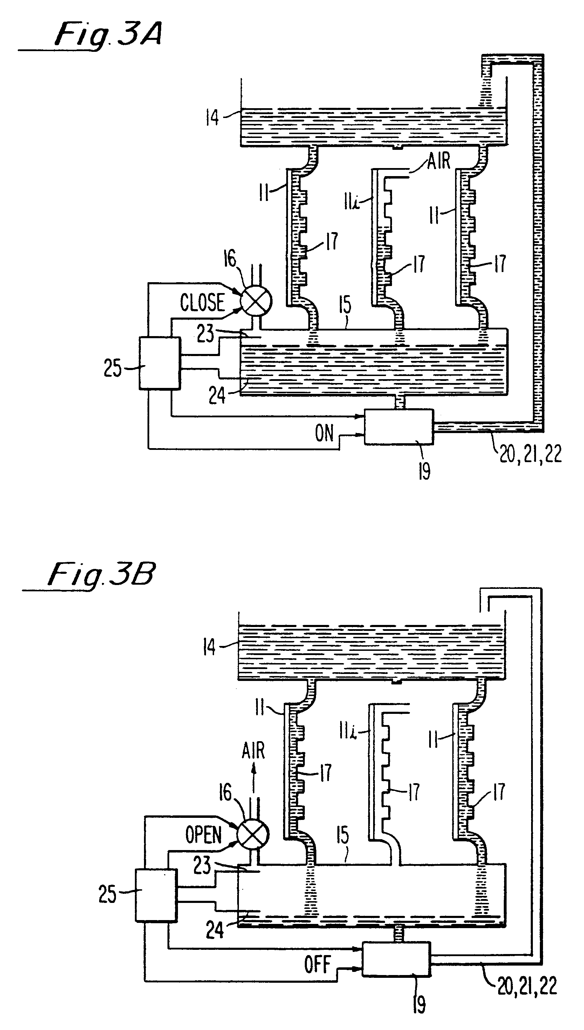

Turning next to FIGs. 3A-3D, they show a sequence by which board 11i may be removed from the system without interrupting the cooling system's operation. Initially, as shown in FIG. 3A, board 11i is disconnected from the top reservoir 14. This is achieved via the valved coupler 17a as is shown in FIG. 1. Such a coupler should have a valve on the port which connects to the top reservoir 14 and no valve on the port which connects to the board 11i.

When board 11i is disconnected as shown in FIG. 3A, a large amount of air will be sucked through the conduit 17 on board 11i into the lower reservoir 15. At the same time, any liquid in the conduit on board 11i will drain into the lower reservoir.

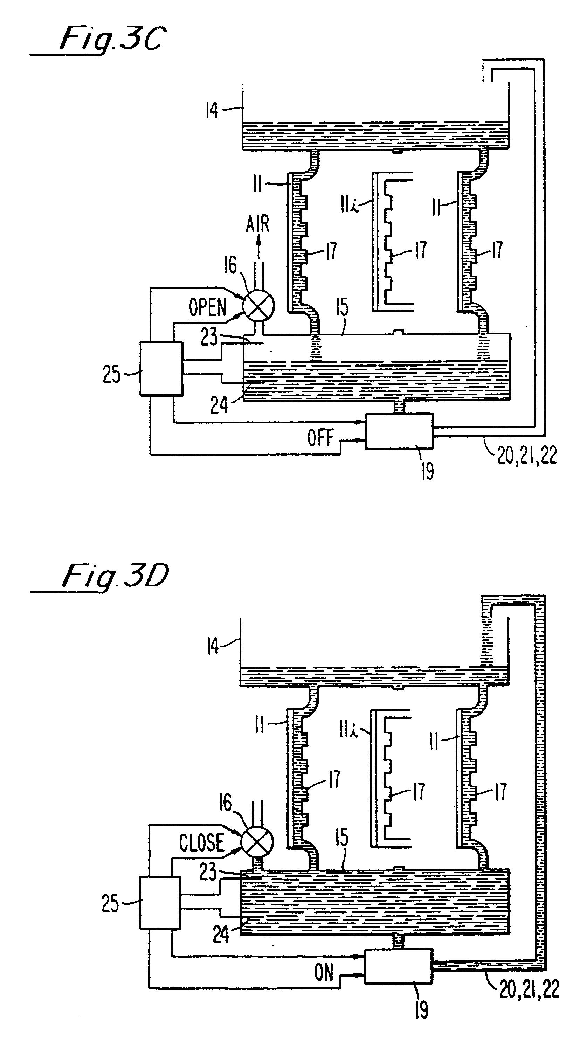

Thus, a state is quickly reached, as shown in FIG. 3B, in which sensor 24 detects that the liquid level in the lower reservoir is too low. Then pump 19 turns off and valve 16 opens. Consequently, as shown in FIG. 3C, the liquid from the top reservoir 14 starts to fill the bottom reservoir 15 due to gravity, and this purges the air from the bottom reservoir.

During the time that the bottom reservoir is being filled, board 11i with its empty conduit 17 can be disconnected from the bottom reservoir 15. This is achieved via the valved coupler 17h as shown in FIG. 1. Such a coupler should have a valve on the port which connects to the bottom reservoir and no valve on the port which connects to the board.

FIG. 3D shows the result of the above disconnecting step. Also, as shown in FIG. 3D, the system will continue to operate in its normal fashion with board 11i removed after the sensor 23 detects that the bottom reservoir is full and turns pump 19 back on.

Consider now page 15 which gives a set of equations that shows how the pressure in the fluid of the FIG. 1 system varies as it travels from the top reservoir 14 to the bottom reservoir 15. Equation 1 is Bernouilli's equation as applied to the FIG. 1 system between two points "a" and "b". Point "a" is at the surface of the fluid in the top reservoir and point "b" is at an arbitrary one of the components 17d and 17e on circuit board 11. In equation 1, P is fluid pressure, $\rho$ is fluid density, V is fluid velocity, g is gravity, h is height, and L is pressure losses.

Equation 1 can be simplified if the top reservoir 14 is made large relative to the flow rate of fluid from that reservoir. This reduces the velocity of the fluid in the top reservoir to essentially zero as stated by equation 2. Substituting equation 2 into equation 1 and solving the result for the pressure $P_b$ yields equation 3.

In equation 3, the term $P_a$ is atmospheric pressure since the top reservoir 14 is open to the atmosphere. Thus, in order for the pressure at point "b" to be subatmospheric, the sum of the two rightmost terms in equation 3 must be larger than the third term from the right. This is stated by equation 4.

All of the remaining equations 5 thru 15 give an example of how the constraint of equation 4 can be met. Initially, one should pick the flow rate Q of the fluid through each of the cooling modules 17d such that the electrical components are properly cooled. For example, as stated in equation 5, one suitable Q is 25 milliliters per second.

From the quantity Q, the total flow rate $Q_T$ through valve 17a can be calculated simply by multiplying Q by the number of parallel output ports from the manifold 17c. For example, if there are eight output ports, then the total flow rite $Q_T$ through valve 17a is 200 milliliters per second, as stated by equation 6. This flow rate $Q_T$ is achieved by properly selecting the pump 19.

Given $Q_T$, the pressure drop across valve 17a can be calculated based on empirical data for the particular valve that is being employed. For example, when the flow rate is 200 milliliters per second, a

4

series H single shut-off valve having a one-half inch diameter from Snap-Tight, Inc. produces a pressure drop of $4{,}4816 \cdot 10^3$ Pa (0.65 psi). This is stated by equation 7.

After the fluid passes through the valve 17a, it flows in a downward direction to manifold 17c. Due to this drop in height, a pressure increase will occur. However, if the drop in height is suitably limited, then this pressure increase will not exceed the pressure drop in valve 17a. For example, if the drop in height is 15,24 cm (six inches), then this pressure increase will only be approximately $1{,}379 \cdot 10^3$ Pa (0.2 psi) as stated by equation 8.

Each time the fluid passes through one of the cooling modules 17d, additional pressure drops occur. Part of this pressure drop is caused by the rapid expansion which the fluid undergoes when it enters the cooling module. This pressure drop can be expressed as an expansion head loss $H_E$ as is stated by equation 9. In that equation, the term $k_e$ is a constant which depends upon the ratio of the diameters of components 17d and 17e. For the diameters as stated by equation 10, $k_e$ is equal to 0.42. Substituting that value of $k_e$ into equation 9 yields equation 11 which says the head loss $H_E$ for the rapid expansion portion of component 17d is 10,29 cm (4.05 inches).

Another pressure drop is also incurred each time the fluid leaves a cooling module 17d due to the rapid contraction which occurs. This pressure drop can be expressed as a contraction head loss $H_C$ as is stated by equation 12. In that equation, $k_c$ is a constant which also depends upon the diameter of the components 17d and 17e. For the diameter values given by equation 13, $k_c$ equals 0.32. Substituting a $k_c$ of 0.32 into equation 12 yields equation 14 which says the contraction head loss $H_C$ is 8,0 cm (3.07 inches).

Thus the total head loss for one cooling module 17d is 10,29 cm (4.05 inches) plus 7,80 cm (3.07 inches) or 18,14 cm (7.14 inches). This is stated by equation 15. So long as successive cooling modules 17d are placed less than 18,14 cm (7.14 inches) apart, the pressure losses through those modules will be greater than the pressure increase which is caused by the fluid's drop in height as it passes from the top of the printed circuit board to the bottom.

Next, reference should be made to page 16 which gives a set of equations that describe the operation of the FIG. 1 system under the condition where pump 19 is turned off and valve 16 is open. This condition occurs when fluid in the top reservoir 14 flows to the bottom reservoir 15 under the force of gravity to purge air from the bottom reservoir.

Under this operating condition, it is again desirable to have the fluid pressure in the cooling modules 17b to be subatmospheric so that the fluid does not squirt out of the conduit 17. Thus, the previously described constraint of equation 4 at page 15 must again be met; and it is rewritten as equation 1 at page 16. Equation 1 contains a loss term $L_{ab}$ which can be expressed as equation 2 wherein $K_c$ is a constant for valve 17a; $V_c$ is the velocity of the fluid as it enters valve 17a; n is the number of cooling modules 17d to point "b"; $K_b$ is a constant for one cooling module 17d; and $V_b$ is the fluid velocity as it enters through cooling module 17d.

Based on the number of output ports from manifold 17c and the relative diameters of components 17b and 17c, the fluid velocities $V_b$ and $V_c$ are related as stated by equation 3. Substituting equations 2 and 3 into equation 1 yields equation 4. There the velocity $V_c$ is an unknown since pump 19 is off. However, the velocity $V_c$ can be eliminated from equation 4 by applying Bernoulli's equation between points "a" and "e" in the FIG. 1 system, solving it for $V_c$, and substituting the result into equation 4.

Equation 5 is Bernoulli's equation between points "a" and "e". In it, pressures $P_a$ and $P_e$ are both atmospheric since valve 16 is open; and velocity $V_a$ is again zero. This is stated by equation 6. Substituting equation 6 into equation 5 yields equation 7.

Included in equation 7 is a loss term $L_{ae}$. It equals all of the losses which the fluid undergoes as it travels from point "a" to point "e". Those losses can be expressed as equation 8 wherein N is the total number of cooling modules 17d in one column on printed circuit board 11; $K_d$ is a constant for valve 17h; and $V_d$ is the fluid velocity as it enters valve 17h.

Based on the number of input ports to manifold 17f and on the relative diameters of components 17d, 17e and 17g, the velocities at points "c", "d" and "e" are related as stated by equation 9. Substituting equations 8 and 9 into equation 7 yields equation 10. That equation can be solved for velocity $V_c$; the result can then be substituted into equation 4; and this yields equation 11.

Equation 11 states a constraint on the system parameters which, if met, will cause the fluid pressure in the modules 17d to be subatmospheric when pump 19 is not running. One way in which equation 11 can be met, as an example, is as follows.

Let $\rho = 998$ kg/m³ (water), $K_c = 1798$ kg/m³, $K_d = K_c$, $K_b = 396$ kg/m³, $C_b = 1.929$, $C_e = 1$, $C_d = 1$, $h_a = 0$, $h_e = -30''$, $h_a - h_b = 6'' + 2n''$, $N = 9$, and n is an integer from 1 to 9. Substituting these values into equation 11 yields Table 1 below wherein $X_L$ is the value of the lefthand side of equation 11 in FIG. 5 and $X_R$ is the value of the righthand side of equation 11.

# EP 0 290 497 B1

Table 1

| n | $X_L$ | $X_R$ | $X_L-X_R$ | $X_L/X_R$ |
|---|-------|-------|-----------|-----------|
| 1 | 2,686 | 2,230 | 456 | 1.204 |
| 2 | 3,269 | 2,788 | 481 | 1.173 |
| 3 | 3,851 | 3,345 | 506 | 1.151 |
| 4 | 4,434 | 3,903 | 531 | 1.136 |
| 5 | 5,016 | 4,460 | 556 | 1.125 |
| 6 | 5,599 | 5,018 | 581 | 1.116 |
| 7 | 6,181 | 5,575 | 606 | 1.109 |
| 8 | 6,764 | 6,133 | 631 | 1.103 |
| 9 | 7,346 | 6,690 | 656 | 1.098 |

eq.1    $P_a + \frac{1}{2}\rho V^2_a + \rho gh_a = P_b + \frac{1}{2}\rho V^2_b + \rho gh_b + L_{ab}$

eq.2    $V_a = 0$

eq.3    $P_b = P_a + \rho g (h_a - h_b) - \frac{1}{2}\rho V^2_b - L_{ab}$

eq.4    if $P_b$ subatmospheric

then $\frac{1}{2}\rho V^2_b + L_{ab} > \rho g (h_a - h_b)$

eq.5    $Q = 25ml/sec$

eq.6    $Q_T = 200 \ ml/sec$

eq.7    $\Delta P$ for 1,27 cm (1/2") dia valve $= 4,4816 \cdot 10^3$ Pa (0.65 psi)

eq.8    pg $(h_a - h_b)$ for 15,24 cm (6") of $H_2O \cong 1,379 \cdot 10^3$ Pa (0.2 psi

eq.9

$$He = \frac{k_e V^2}{2g}$$

eq.10    dia. 17e $= 0,381$ cm (0.15"), dia 17d $= 0,635$ cm (0.25"), ke0.42

eq.11    $H_e = 10,29$ cm (4.05")

eq.12

$$Hc = \frac{k_c V^2}{2g}$$

eq.13    dia. 17e $= 0,381$ cm (0.15"), dia. 17d $= 0,635$ cm (0.25"), kc $= 0.32$

eq.14    $H_c = 7,80$ cm (3.07")

eq.15    $H_e + H_c = 18,14$ cm (7.14")

eq.1    $\frac{1}{2}\rho V^2_b + L_{ab} > \rho g (h_a - h_b)$

eq.2    $L_{ab} = k_c V^2_c + nK_b V^2_b$

eq.3    $V^2_b = C_b V^2_c$

eq.4    $\frac{1}{2}\rho C_b V^2_c + K_c V^2_c + nK_b C_b V^2_c > \rho g (h_a - h_b)$

eq.5    $P_a + \frac{1}{2}\rho V^2_a + \rho gh_a = P_e + \frac{1}{2}\rho V^2_e + \rho gh_e + L_{ae}$

eq.6    $P_a = P_e$ , $V_a = 0$

eq.7    $\rho gh_a = \frac{1}{2}\rho V^2_e + \rho gh_e + L_{ae}$

eq.8    $L_{ae} = K_c V^2_c + NK_b V^2_b + K_d V^2_d$

eq.9    $V^2_e = C_e V^2_c$, $V^2_d = C_d V^2_c$

eq.10    $\rho g (h_a - h_e) = \frac{1}{2}\rho C_e V^2_c + K_c V^2_c + NK_b C_b V^2_c + K_d C_d V^2_c$

eq.11    $[\frac{1}{2}\rho C_b + K_c + nk_b C_b] (h_a - h_e) > [\frac{1}{2}\rho C_e + K_c + NK_b C_b + K_d C_d] (h_a - h_b)$

6

EP 0 290 497 B1

**Claims**

1. A leak tolerant cooling system, which cools electrical components with a liquid, comprising:
a frame (10) holding a plurality of said electrical components;
a top reservoir (14), mounted on said frame (10) above said components, holding said liquid;
a conduit means (17), coupled to said top reservoir (14) and said components, conveying said liquid in a downward direction from said top reservoir (14) over said components;
a bottom reservoir (15), coupled to said conduit means (17) below said components, receiving said liquid from said conduit means (17) as well as any air which happens to leak into said conduit means (17); and
a control means, coupled to said bottom reservoir (15);
said control means including: (a) a pump (19) which sucks said liquid and said air through said conduit means (17) at subatmospheric pressures and into said bottom reservoir (15) in response to a control signal;
(b) a means (25) for generating said control signal beginning when said liquid in said bottom reservoir (15) is at a predetermined high level and continuing until a certain amount of said liquid in said bottom reservoir (15) is displaced with said air and reaches a predetermined low level; and (c) a valve (16) positioned on said bottom reservoir (15) above the liquid therein which opens when said pump (19) is stopped and allows said air to be pushed out of said bottom reservoir (15) through said conduit means (17) and into said bottom reservoir (15) due to gravity.

2. A system according to claim 1 wherein said components are mounted on a plurality of printed circuit boards (11) which are held in a removable fashion by said frame (10); each board (11) further containing a respective portion of said conduit means (17) which includes (a) a first valved coupler (17a) with a valve on one port that is coupled to said top reservoir (14) and no valve on another port that is coupled to the board (11), and (b) a second valved coupler (17h) with a valve on one port that is coupled to said bottom reservoir (15) and no valve on another port that is coupled to the board (11).

3. A system according to claim 1 wherein said conduit means (17) is shaped such that subatmospheric pressures are developed in said liquid as said liquid flows in said downward direction from said top reservoir (14) and through said conduit (17) due to gravity when said pump is stopped.

4. A system according to claim 1 wherein said conduit means (17) includes a plurality of modules (17d) which carry said liquid over respective ones of said electrical components (11), with each module (17d) producing a rapid liquid expansion and a rapid liquid contraction for attaining said subatmospheric pressure in said liquid as it flows through the module (17d).

5. A system according to claim 1 wherein said conduit means (17) includes a means which decreases the pressure in said liquid below atmospheric by producing pressure drops that are proportional to the square of the velocity with which said liquid flows over said components (13) due to gravity;
and wherein said means which decreases the pressure below atmospheric includes a plurality of modules which are disposed in a column in said downward direction and are spaced apart by a distance which is less than the pressure drop, in terms of head loss, which each module produces.

6. A system according to claim 5 wherein said means which decreases the pressure below atmospheric includes a valve.

7. A system according to claim 5 wherein said means which decreases the pressure below atmospheric includes a passage which rapidly contracts said liquid.

8. A system according to claim 5 wherein said means which decreases the pressure below atmospheric includes a passage which rapidly expands said liquid.

**Patentansprüche**

1. Leckbeständiges Kühlsystem, welches elektrische Bauteile mit einer Flüssigkeit kühlt, umfasssend:
einen Rahmen (10), der eine Vielzahl elektrischer Bauteile trägt;
ein an den Rahmen (10) oberhalb der Bauteile angebrachtes oberes Reservoir (14), welches die

7

EP 0 290 497 B1

Flüssigkeit hält;

eine an das obere Reservoir (14) und die Bauteile angeschlossene Leitungseinrichtung (17), die die Flüssigkeit vom oberen Reservoir (14) oberhalb der Bauteile in Abwärtsrichtung überführt;

ein an die Leitungseinrichtung (17) unterhalb der Bauteile angeschlossenes unteres Reservoir (15), welches die Flüssigkeit aus der Leitungseinrichtung (17) wie auch jegliche Luft empfängt, die möglicherweise in die Leitungseinrichtung (17) einleckt; und

eine an das untere Reservoir (15) angeschlossene Steuereinrichtung, wobei die Steuereinrichtung einschließt: (a) eine Pumpe (19), die die Flüssigkeit und die Luft durch die Leitungseinrichtung (17) bei weniger als Atmosphärendruck und in das untere Reservoir (15) als Antwort auf ein Steuersignal saugt; (b) eine Einrichtung (25) zum Erzeugen des Steuersignals beginnend dann, wenn sich die Flüssigkeit in dem unteren Reservoir (15) an einem vorbestimmten hohen Pegel befindet und weiterdauernd, bis eine gewisse Menge der Flüssigkeit in dem unteren Reservoir (15) von der Luft verdrängt ist und einen vorbestimmten niedrigen Pegel erreicht; und (c) ein auf dem unteren Reservoir (15) oberhalb der darin befindlichen Flüssigkeit angebrachtes Ventil (16), welches aufmacht, wenn die Pumpe (19) angehalten wird und das Schieben der Luft aus dem unteren Reservoir (15) durch die Leitungseinrichtung (17) und in das untere Reservoir (15) auf Grund von Schwerkraft ermöglicht.

2. System nach Anspruch 1, wobei die Bauteile auf einer Vielzahl von gedruckten Schaltungsplatten (11) angebracht sind, die von dem Rahmen (10) auf bewegliche Weise gehalten werden; wobei jede Platte (11) weiter jeweils einen Teil der Leitungseinrichtung (17) enthält, welche einschließt (a) einen ersten mit einem Ventil versehenen Koppler (17a) mit einem Ventil an einem Ausgang, der an das obere Reservoir (14) angeschlossen ist und ohne Ventil am anderen Ausgang, der an die Platte (11) angeschlossen ist und (b) einen zweiten mit einem Ventil versehenen Koppler (17h) mit einem Ventil an einem Ausgang, der an das untere Reservoir (15) angeschlsosen ist und ohne Ventil am anderen Ausgang, der an die Platte (11) angeschlossen ist.

3. System nach Anspruch 1, wobei die Leitungseinrichtung (17) so gestaltet ist, daß sich in der Flüssigkeit ein Druck von weniger als Atmosphärendruck entwickelt, wenn die Flüssigkeit in der Abwärtsrichtung vom oberen Reservoir (14) und durch die Leitung (17) auf Grund von Schwerkraft fließt, wenn die Pumpe angehalten ist.

4. System nach Anspruch 1, wobei die Leitungseinrichtung (17) eine Vielzahl von Modulen (17d) einschließt, die die Flüssigkeit über jeweils eines der elektrischen Bauteile (11) führt, wobei jedes Modul (17d) eine schnelle Flüssigkeitsentspannung und eine schnelle Flüssigkeitskontraktion zum Erreichen des Drucks von weniger als Atmosphärendruck in der Flüssigkeit erzeugt, wenn sie durch das Modul (17d) fließt.

5. System nach Anspruch 1, wobei die Leitungseinrichtung (17)) eine Einrichtung einschließt, die den Druck in der Flüssigkeit unter den Atmosphärendruck absenkt, indem sie Druckabfälle erzeugt, die proportional zum Quadrat der Geschwindigkeit sind, mit der die Flüssigkeit über die Bauteile 13 auf Grund von Schwerkraft fließt; und wobei die Einrichtung, die den Druck unter den Atmosphärendruck absenkt, eine Vielzahl von Modulen einschließt, die in einer Säule in der Abwärtsrichtung angeordnet sind und voneinander mit einer Entfernung beabstandet sind, die weniger beträgt als der Druckabfall, ausgedrückt als Spitzenverlust, den jedes Modul erzeugt.

6. Verfahren nach Anspruch 5, wobei die Einrichtung, die den Druck unter den Atmosphärendruck absenkt, ein Ventil einschließt.

7. Verfahren nach Anspruch 5, wobei die Einrichtung, die den Druck unter den Atmosphärendruck absenkt, einen Durchgang einschließt, der die Flüssigkeit schnell kontrahiert.

8. Verfahren nach Anspruch 5, wobei die Einrichtung, die den Druck unter den Atmosphärendruck absenkt, einen Durchgang einschließt, der die Flüssigkeit schnell expandiert.

**Revendications**

1. Système de refroidissement supportant les fuites, qui refroidit des composants électriques avec un liquide, comprenant :

8

un bâti (10) contenant plusieurs desdits composants électriques ;

un réservoir supérieur (14), monté sur ledit bâti (10) au-dessus desdits composants, contenant ledit liquide ;

un moyen formant conduite (17), couplé audit réservoir supérieur (14) et auxdits composants , conduisant ledit liquide vers le bas dudit réservoir supérieur (14) sur lesdits composants ;

un réservoir inférieur (15), couplé audit moyen formant conduite (17) en-dessous desdits composants, recevant ledit liquide dudit moyen formant conduite (17) ainsi que tout air qui peut fuir dans ledit moyen formant conduite (17); et

un moyen de commande, couplé audit réservoir inférieur (15) ;

ledit moyen de commande comprenant : (a) une pompe (19) qui aspire ledit liquide et ledit air par l'intermédiaire dudit moyen formant conduite (17) à pressions subatmosphériques et dans ledit réservoir inférieur (15), en réponse à un signal de commande, (b) un moyen (25) pour engendrer ledit signal de commande commençant lorsque ledit liquide dans ledit réservoir inférieur (15) atteint un niveau supérieur prédéterminé, et continuant jusqu'à ce qu'une certaine quantité dudit liquide dans ledit réservoir inférieur (15) soit déplacée avec ledit air et atteigne un niveau inférieur prédéterminé ; et (c) une vanne (16) positionnée sur ledit réservoir inférieur (15) au-dessus du liquide, qui s'ouvre lorsque ladite pompe (19) est arrêtée et permet audit air de s'échapper dudit réservoir inférieur (15) par l'intermédiaire dudit moyen formant conduit (17) et dans ledit réservoir inférieur (15) à cause de la gravité.

2. Système selon la revendication 1, dans lequel lesdits composants sont montés sur plusieurs cartes de circuits imprimés (11) qui sont maintenus de manière détachable par ledit bâti (10) ; chaque carte (11) contenant en outre une partie respective dudit moyen formant conduite (17) qui contient (a) un premier accouplement de vanne (17a) avec une vanne sur un orifice qui est couplée audit réservoir supérieur (14) et sans vanne sur l'autre orifice qui est couplé à la carte (11), et (b) un second accouplement de vanne (17h) avec une vanne sur un orifice qui est coupé audit réservoir (15) et sans vanne sur l'autre orifice qui est couplé à la carte (11).

3. Système selon la revendication 1, dans lequel ledit moyen formant conduite (17) est configuré de telle façon que les pressions subatmosphériques se développent dans ledit liquide alors que ledit liquide s'écoule dans ladite direction vers le bas dudit réservoir supérieur (14) et par l'intermédiaire de ladite conduite (17) à cause de la gravité lorsque ladite pompe est arrêtée.

4. Système selon la revendication 1, dans lequel ledit moyen formant conduite (17) comprend plusieurs modules (17d) qui transportent ledit liquide sur lesdits composants électriques (11), avec chaque module (17d) produisant une expansion rapide du liquide et une contraction rapide du liquide pour obtenir ladite pression subatmosphérique dans ledit liquide lorsqu'il s'écoule au travers du module (17d).

5. Système selon la revendication 1, dans lequel ledit moyen formant conduite (17) va diminuer la pression dans ledit liquide au-dessous de la pression atmosphérique en produisant des chutes de pression qui sont proportionnelles au carré de la vitesse avec laquelle ledit liquide s'écoule sur lesdits composants (13) à cause de la gravité ;

et dans lequel ledit moyen qui diminue la pression au-dessous de la pression atmosphérique comprend plusieurs modules qui sont disposés en une colonne dans ladite direction vers le bas et sont séparés les uns des autres d'une distance qui est inférieure à la chute de pression, en terme de perte de chaleur, que chaque module produit.

6. Système selon la revendication 5, dans lequel ledit moyen qui diminue la pression au-dessous de la pression atmosphérique comprend une vanne.

7. Système selon la revendication 5, dans lequel ledit moyen qui diminue la pression au-dessous de la pression atmosphérique comprend un passage qui contracte rapidement ledit liquide.

8. Système selon la revendication 5, dans lequel ledit moyen qui diminue la pression au-dessous de la pression atmosphérique comprend un passage qui dilate ledit liquide.

_Fig.1_

_Fig.2A_

_Fig.2B_

_Fig.2C_

_Fig.2D_

EP 0 290 497 B1

## Fig.3A

## Fig.3B

13

*Fig.3C*

*Fig.3D*